(19) **Europäisches Patentamt**
**European Patent Office**
**Office européen des brevets**

(11) **EP 4 130 114 A1**

(12) # EUROPEAN PATENT APPLICATION
published in accordance with Art. 153(4) EPC

(43) Date of publication:
**08.02.2023 Bulletin 2023/06**

(21) Application number: **21780239.6**

(22) Date of filing: **29.03.2021**

(51) International Patent Classification (IPC):
***C08J 5/24*** (1974.07)      ***C04B 41/83*** (1985.01)

(52) Cooperative Patent Classification (CPC):
**C04B 41/83; C08J 5/24**

(86) International application number:
**PCT/JP2021/013397**

(87) International publication number:
**WO 2021/200871 (07.10.2021 Gazette 2021/40)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **31.03.2020   JP 2020063697**

(71) Applicant: **Denka Company Limited
Tokyo 103-8338 (JP)**

(72) Inventors:
- **KANEKO, Eri
  Tokyo 103-8338 (JP)**
- **OKI, Mana
  Tokyo 103-8338 (JP)**
- **INOUE, Saori
  Tokyo 103-8338 (JP)**
- **TSUJI, Kohji
  Tokyo 103-8338 (JP)**

(74) Representative: **Hoffmann Eitle
Patent- und Rechtsanwälte PartmbB
Arabellastraße 30
81925 München (DE)**

(54) **SEMICURED PRODUCT COMPLEX AND METHOD FOR PRODUCING SAME, CURED PRODUCT COMPLEX AND METHOD FOR PRODUCING SAME, AND THERMOSETTING COMPOSITION USED TO IMPREGNATE POROUS BODY**

(57)    An aspect of the present invention provides a semi-cured product composite containing: a porous body; and a semi-cured product of a thermally curable composition impregnated in the porous body, wherein the thermally curable composition contains an epoxy compound and a cyanate compound, and an equivalent ratio of an epoxy group of the epoxy compound to a cyanate group of the cyanate compound in the thermally curable composition is 1.0 or more.

EP 4 130 114 A1

## Description

### Technical Field

The present invention relates to a semi-cured product composite and a method for producing the same, a cured product composite and a method for producing the same, and a thermally curable composition used for being impregnated into a porous body.

### Background Art

In electronic components such as an LED lighting device and an in-vehicle power module, it is a problem to efficiently dissipate heat generated during use. In order to solve this problem, measures have been taken such as a method for increasing the thermal conductivity of an insulating layer of a printed wiring board on which an electronic component is mounted and a method for attaching an electronic component or a printed wiring board to a heat sink via an electrically insulating thermal interface material. As the insulating layer and the thermal interface material, a composite (heat dissipation member) formed of a resin and ceramics such as boron nitride is used.

### Citation List

### Patent Document

[Patent Document 1] International Publication No. 2014/196496

### Summary of Invention

### Technical Problem

Since the composite as described above is used by being adhered to an adherend such as an electronic component, it is desirable that a state of high adhesiveness can be maintained for a long time because handling properties are excellent. In the composite, when the resin is in a semi-cured state and has a viscosity within a specific range, the adhesive property becomes excellent. In a conventional composite, it is difficult to hold a semi-cured resin in a desired viscosity range because the viscosity of the semi-cured resin tends to rapidly increase.

An object of an aspect of the present invention is, in a semi-cured product composite in which a porous body is impregnated with a semi-cured product of a thermally curable composition, to maintain the semi-cured product within a desired viscosity range.

### Solution to Problem

The present inventors have found that a semi-cured product of a thermally curable composition containing specific amounts of an epoxy compound and a cyanate compound does not rapidly increase in viscosity and is maintained in a desired viscosity range (for example, a viscosity range in which adhesiveness is excellent). Accordingly, the present inventors have found that a semi-cured product composite obtained by impregnating a porous body with a semi-cured product of the curable composition can maintain a state of high adhesiveness, and have completed the present invention.

An aspect of the present invention provides a semi-cured product composite comprising: a porous body; and a semi-cured product of a thermally curable composition impregnated in the porous body, wherein the thermally curable composition comprises an epoxy compound and a cyanate compound, and an equivalent ratio of an epoxy group of the epoxy compound to a cyanate group of the cyanate compound in the thermally curable composition is 1.0 or more.

The cyanate compound can increase the heat resistance of the composite by being added thereto, but on the other hand, the viscosity of the semi-cured resin is likely to increase rapidly. In the semi-cured product composite, when the cyanate compound and the epoxy compound are contained in the specific balance, a rapid increase in viscosity of the semi-cured product may be suppressed.

Another aspect of the present invention provides a method for producing a semi-cured product composite, comprising: impregnating a porous body with a thermally curable composition comprising an epoxy compound and a cyanate compound; and heating the porous body impregnated with the thermally curable composition at a temperature T1 at which the cyanate compound reacts, wherein an equivalent ratio of an epoxy group of the epoxy compound to a cyanate group of the cyanate compound in the thermally curable composition is 1.0 or more.

Another aspect of the present invention provides a cured product composite comprising: a porous body; and a cured product of a thermally curable composition impregnated in the porous body, wherein the thermally curable composition comprises an epoxy compound and a cyanate compound, and an equivalent ratio of an epoxy group of the epoxy compound to a cyanate group of the cyanate compound in the thermally curable composition is 1.0 or more.

Another aspect of the present invention provides a method for producing a cured product composite, comprising: impregnating a porous body with a thermally curable composition comprising an epoxy compound and a cyanate compound; and heating the porous body impregnated with the thermally curable composition at a temperature T1 at which the cyanate compound reacts; and then at a temperature T2 higher than the temperature T1, wherein an equivalence ratio of an epoxy group of the epoxy compound to a cyanato group of the cyanate compound in the thermally curable composition is 1.0 or more.

Another aspect of the present invention provides a thermally curable composition used for being impregnated into a porous body, the thermally curable composition comprising: an epoxy compound; and a cyanate compound, wherein an equivalent ratio of an epoxy group of the epoxy compound to a cyanate group of the cyanate compound is 1.0 or more.

**Advantageous Effects of Invention**

According to an aspect of the present invention, in a semi-cured product composite in which a porous body is impregnated with a semi-cured product of a thermally curable composition, the semi-cured product can be maintained within a desired viscosity range.

**Brief Description of Drawings**

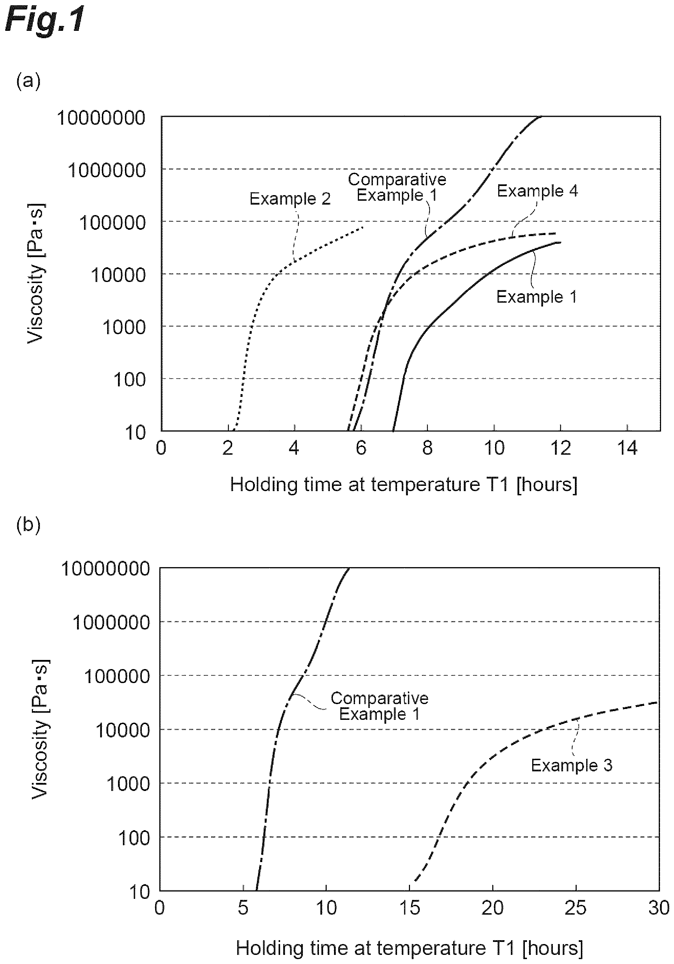

FIG. 1 is a graph showing viscosity behaviors of thermally curable compositions according to Examples and Comparative Example.

**Description of Embodiments**

Hereinafter, embodiments of the present invention will be described. However, the present invention is not limited to the following embodiments.

<Semi-cured product composite>

A semi-cured product composite according to an embodiment contains a porous body and a semi-cured product of a thermally curable composition impregnated in the porous body.

The porous body has a structure in which a plurality of fine pores (hereinafter also referred to as "pores") are formed. The pores in the porous body may be at least partially connected to each other to form continuous pores.

The porous body may be formed of an inorganic compound, and is preferably formed of a sintered body of an inorganic compound. The sintered body of the inorganic compound may be a sintered body of an insulator. The insulator in the sintered body of the insulator preferably contains a non-oxide such as a carbide, a nitride, a diamond, or a graphite, and more preferably contains a nitride. The carbide may be silicon carbide or the like. The nitride may contain at least one nitride selected from the group consisting of boron nitride, aluminum nitride, and silicon nitride, and preferably contains boron nitride. That is, the porous body may preferably be formed of a sintered body of an insulating material containing boron nitride, and more preferably formed of a boron nitride sintered body. In the case where the porous body is formed of a boron nitride sintered body, the boron nitride sintered body may be formed by sintering primary particles of boron nitride. As the boron nitride, either amorphous boron nitride or hexagonal boron nitride can be used.

The heat conductivity of the porous body may be, for example, 30 W/(m K) or more, 50 W/(m K) or more, or 60 W/(m K) or more. The superior thermal conductivity of the porous body can reduce the thermal resistance of the resulting semi-cured product composite. The heat conductivity of the porous body is measured by a laser flash method with respect to a sample obtained by forming the porous body into length 10 mm × width 10 mm × thickness 1 mm.

The average pore diameter of the pores in the porous body may be, for example, 0.5 $\mu$m or more, and is preferably 0.6 $\mu$m or more, more preferably 0.8 $\mu$m or more, and even more preferably 1 $\mu$m or more, from the viewpoint that the pores can be suitably filled with the thermally curable composition. The average pore diameter of the pores is preferably 3.5 $\mu$m or less, 3.0 $\mu$m or less, 2.5 $\mu$m or less, 2.0 $\mu$m or less, or 1.5 $\mu$m or less, from the viewpoint of improving the insulation properties of the semi-cured product composite.

The average pore diameter of the pores in the porous body is defined as the pore diameter at which the cumulative pore volume reaches 50% of the total pore volume in a pore diameter distribution (horizontal axis: pore diameter, vertical axis: cumulative pore volume) measured using a mercury porosimeter. A mercury porosimeter manufactured by Shimadzu Corporation can be used as the mercury porosimeter, and the measurement is performed while increasing the pressure from 0.03 atm to 4000 atm.

The proportion of the pores in the porous body (porosity) based on the total volume of the porous body is preferably 10% by volume or more, 20% by volume or more, or 30% by volume or more, from the viewpoint of suitably improving the strength of the semi-cured product composite by filling with the thermally curable composition, and is preferably 70% by volume or less, more preferably 60% by volume or less, and even more preferably 50% by volume or less, from the viewpoint of improving the insulation and thermal conductivity of the semi-cured product composite. The proportion (porosity) is calculated by the following formula:

$$\text{Porosity (\% by volume)} = [1 - (D1 / D2)] \times 100$$

wherein a bulk density D1 (g/cm$^3$) obtained from the volume and mass of the porous body and a theoretical density D2 of a material constituting the porous body (for example, 2.28 g/cm$^3$ in the case of boron nitride).

The proportion of the porous body in the semi-cured product composite is preferably 30% by volume or more, more preferably 40% by volume or more, and still more preferably 50% by volume or more, from the viewpoint of improving the insulating properties and thermal conductivity of the semi-cured product composite. The proportion of the porous body in the semi-cured product composite may be, for example, 90% by volume or less, 80% by volume or less, 70% by volume or less, or 60% by volume or less.

The thermally curable composition contains an epoxy compound and a cyanate compound as thermally curable compounds.

As the epoxy compound, for example, an epoxy compound having a desired viscosity as a semi-cured product or an epoxy compound having a viscosity suitable for impregnation when impregnated in the porous body may be appropriately selected. Examples of the epoxy compound include 1,6-bis(2,3-epoxypropan-1-yloxy) naphthalene, a bisphenol A type epoxy resin, a bisphenol F type epoxy resin, and a dicyclopentadiene type epoxy resin. Among these, 1,6-bis(2,3-epoxypropan-1-yloxy) naphthalene is commercially available as, for example, HP-4032D (trade name, manufactured by DIC Corporation). In addition, as commercially available products of the epoxy compound, EP-4000L, EP4088L, EP3950 (trade names, manufactured by ADEKA Corporation), EXA-850CRP (trade name, manufactured by DIC Corporation), jER807, jER152, YX8000, YX8800 (trade names, manufactured by Mitsubishi Chemical Corporation) are used. As the epoxy compound, an epoxy compound having a vinyl group may be used. Examples of commercially available epoxy compounds having vinyl groups include TEPIC-FL, TEPIC-VL (trade names, manufactured by Nissan Chemical Industries, Ltd.), MA-DGIC, DA-MGIC (trade names, manufactured by SHIKOKU CHEMICALS CORPORATION).

The content of the epoxy compound is preferably 30% by mass or more, more preferably 40% by mass or more, and even more preferably 50% by mass or more, and is preferably 85% by mass or less, more preferably 75% by mass or less, and even more preferably 70% by mass or less, based on the total amount of the thermally curable composition.

Examples of the cyanate compound include dimethyl methylene bis(1,4-phenylene) biscyanate and bis(4-cyanate phenyl) methane. Dimethylmethylene bis(1,4-phenylene) biscyanate is commercially available as, for example, TA-CN (trade name, manufactured by Mitsubishi Gas Chemical Co., Ltd.).

The content of the cyanate compound is preferably 5% by mass or more, more preferably 8% by mass or more, and even more preferably 10% by mass or more, and is preferably 51% by mass or less, more preferably 40% by mass or less, and even more preferably 30% by mass or less, based on the total amount of the thermally curable composition.

From the viewpoint of maintaining the thermally curable composition in a semi-cured state having a desired viscosity (details will be described later), the equivalent ratio of the epoxy group of the epoxy compound to the cyanate group of the cyanate compound (epoxy group equivalent / cyanate group equivalent) contained in the thermally curable composition is 1.0 or more. The equivalent ratio is preferably 1.5 or more, more preferably 2.0 or more, and even more preferably 2.5 or more, and is preferably 6.0 or less, 5.5 or less, 5.0 or less, 4.5 or less, 4.0 or less, 3.5 or less, or 3.0 or less, from the viewpoint of facilitating impregnation of the thermally curable composition and from the viewpoint of improving heat resistance of the semi-cured product composite.

The thermally curable composition may further contain additional thermally curable compounds other than the epoxy compound and the cyanate compound.

The thermally curable composition may further contain a curing agent in addition to the epoxy compound and the cyanate compound from the viewpoint of more easily maintaining a semi-cured state having a desired viscosity. In one embodiment, the thermally curable composition contains a curing agent for the epoxy compound. The curing agent for the epoxy compound is a compound that forms a crosslinked structure with the epoxy compound (cures the epoxy compound).

The epoxy compound curing agent preferably contains at least one selected from the group consisting of a benzoxazine compound, an ester compound, and a phenol compound.

Examples of the benzoxazine compound include bisphenol F-type benzoxazine compounds. The bisphenol F type benzoxazine compound is commercially available as, for example, F-a type benzoxazine (trade name, manufactured by SHIKOKU CHEMICALS CORPORATION).

Examples of the ester compound include diphenyl phthalate and benzyl 2-ethylhexyl phthalate. The ester compound may be an active ester compound. The active ester compound refers to a compound having one or more ester bonds in the structure thereof and having aromatic rings bonded to both sides of the ester bond.

Examples of the phenol compound include phenol, cresol, bisphenol A, bisphenol F, a phenol novolac resin, a cresol novolac resin, a dicyclopentadiene-modified phenol resin, a terpene-modified phenol resin, a triphenolmethane-type resin, a phenol aralkyl resin (having a phenylene skeleton, a biphenylene skeleton, or the like), a naphthol aralkyl resin, and na allyl phenol resin. These may be used alone or as a mixture of two or more thereof. The phenol compounds are commercially available as, for example, TD2131, VH4150 (trade names, manufactured by DIC Corporation), MEHC-7851M, MEHC-7500, MEH8005, MEH8000H (trade names, manufactured by Meiwa Kasei Co., Ltd.).

In the case where the thermally curable composition contains a curing agent for the epoxy compound, the content of the curing agent is preferably 0.1% by mass or more, more preferably 5% by mass or more, and even more preferably 7% by mass or more, and is preferably 30% by mass or less, more preferably 20% by mass or less, and even more preferably 15% by mass or less, based on the total amount of the thermally curable composition.

The thermally curable composition may further contain a curing accelerator in addition to the compounds described above. The curing accelerator contains a component (catalytic curing agent) that functions as a catalyst for the curing reaction. When the thermally curable composition contains the curing accelerator, a reaction between the epoxy compound and the cyanate compound, a self-polymerization reaction of the epoxy compound, and/or a reaction between the epoxy compound and a curing agent for the epoxy compound, which will be described below, may be easily performed, and a semi-cured product may be easily maintained in a semi-cured state having a desired viscosity. Examples of such components include organic metal salts, phosphorus compounds, imidazole derivatives, amine compounds, and cationic polymerization initiators. These curing agents may be used alone or in combination of two or more thereof.

Examples of the organic metal salt include organic metal salts such as bis(2,4-pentanedionato) zinc (II), zinc octylate, zinc naphthenate, cobalt naphthenate, copper naphthenate, iron acetylacetonate, nickel octylate, and manganese octylate.

Examples of the phosphorus compound include tetraphenylphosphonium tetra-p-tolylborate, tetraphenylphosphonium tetraphenylborate, triphenylphosphine, tri-p-tolylphosphine, tris(4-chlorophenyl) phosphine, tris(2,6-dimethoxyphenyl) phosphine, triphenylphosphine triphenylborane, tetraphenylphosphonium dicyanamide, and tetraphenylphosphonium tetra(4-methylphenyl) borate.

Examples of the imidazole derivative include 1-(1-cyanomethyl)-2-ethyl-4-methyl-1H-imidazole, 2-ethyl-4-methylimidazole, 2-methylimidazole, 2-phenylimidazole, 1-cyanoethyl-2-phenylimidazole, 2-phenyl-4,5-dihydroxymethylimidazole, 2-phenyl-4-methyl-5-hydroxymethylimidazole, and 2,4,5 -triphenylimidazole.

Examples of the amine compound include dicyandiamide, triethylamine, tributylamine, tri-n-octylamine, and 1,4-diazabicyclo [2.2.2] octane, 1,8-diazabicyclo [5.4.0] undec-7-ene, benzyldimethylamine, 4-methyl-N,N-dimethylbenzylamine, 2,4,6-tris(dimethylaminomethyl) phenol, and 4-dimethylaminopyridine.

Examples of the cationic polymerization initiator include benzylsulfonium salts, benzylammonium salts, benzylpyridinium salts, benzylphosphonium salts, hydrazinium salts, carboxylic acid ester compounds, sulfonic acid ester compounds, amine imides, antimony pentachloride-acetyl chloride complexes, and diaryliodonium salt-dibenzyloxycopper.

The content of the above-described curing accelerator may be 0.001 parts by mass or more, 0.01 parts by mass or more, or 0.05 parts by mass or more, and may be 1 part by mass or less, 0.8 parts by mass or less, 0.5 parts by mass or less, 0.3 parts by mass or less, or 0.1 parts by mass or less, based on 100 parts by mass of the total of the epoxy compound, the cyanate compound, and the epoxy compound curing agent. When the content of the curing accelerator is within this range, the semi-cured product can be easily maintained at a desired viscosity.

The semi-cured product composite contains a semi-cured product of the thermally curable composition described above. The semi-cured product of the thermally curable composition (also simply referred to as "semi-cured product") refers to a cured product in a state in which a curing reaction of the thermally curable composition partially proceeds. In one embodiment, the semi-cured product contains a reaction product (cured product) of an epoxy compound and a cyanate compound, and an uncured epoxy compound. The semi-cured product may partially contain an uncured cyanate compound, or may partially contain a cured product of an epoxy compound (for example, a cured product obtained by curing an epoxy compound through a self-polymerization reaction).

The fact that the semi-cured product composite contains the semi-cured product can be confirmed by measuring the adhesive strength of the semi-cured product composite measured by the following method. First, a semi-cured product composite is formed into a sheet by a method described later, and this sheet is placed between two copper sheets, heated and pressurized for 5 minutes under conditions of 200°C and 10 MPa, and further heated for 2 hours under conditions of 200°C and atmospheric pressures to obtain a laminate. Next, a 90° peel test is performed in accordance with JIS K 6854-1:1999 "Adhesives - Determination of peel strength of bonded assemblies" to measure the area of the cohesive failure portion. As a result, when the area of the cohesive failure portion is 30% by area or more, it can be said that the semi-cured product is contained in the semi-cured product composite.

Next, a method for producing a semi-cured product composite will be described. In one embodiment, a method for producing a semi-cured product composite includes a step of impregnating a porous body with a thermally curable composition containing an epoxy compound and a cyanate compound (impregnation step), and a step of heating the porous body impregnated with the thermally curable composition at a temperature T1 at which the cyanate compound reacts (semi-curing step). Aspects of the thermally curable composition are as described above.

In the impregnation step, in one embodiment, first, the above-described porous body is prepared. The porous body may be produced by sintering a raw material or the like, or a commercially available product may be used. When the porous body is a sintered body of an inorganic compound, the porous body can be obtained by sintering a powder containing the inorganic compound. That is, in one embodiment, the impregnation step includes a step of sintering powder containing an inorganic compound (hereinafter also referred to as inorganic compound powder) to obtain a sintered body of the inorganic compound which is a porous body.

The sintered body of the inorganic compound may be prepared as a porous body by spheroidizing a slurry containing powder of the inorganic compound with a spray dryer or the like, further molding the spheroidized slurry, and then sintering the molded slurry. For the molding, a mold may be used, or a cold isostatic pressing (CIP) method may be used.

At the time of sintering, a sintering aid may be used. Examples of the sintering aid may include oxides of rare earth elements such as yttria oxide, alumina oxide, and magnesium oxide; carbonates of alkali metals such as lithium carbonate and sodium carbonate; and boric acid. When the sintering aid is blended, the addition amount of the sintering aid may be, for example, 0.01 parts by mass or more, or 0.1 parts by mass or more, with respect to 100 parts by mass in total of the inorganic compound and the sintering aid. The addition amount of the sintering aid may be 20 parts by mass or less, 15 parts by mass or less, or 10 parts by mass or less, with respect to a total of 100 parts by mass of the inorganic compound and the sintering aid. By setting the addition amount of the sintering aid within the above range, it becomes easy to adjust the average pore diameter of the sintered body within the above range.

The sintering temperature of the inorganic compound may be, for example, 1600°C or higher, or 1700°C or higher. The sintering temperature of the inorganic compound may be, for example, 2200°C or lower, or 2000°C or lower. The sintering time of the inorganic compound may be, for example, 1 hour or more and may be 30 hours or less. The atmosphere during sintering may be, for example, an inert gas atmosphere such as nitrogen, helium, or argon.

For the sintering, for example, a batch furnace, a continuous furnace, or the like can be used. Examples of the batch-type furnace include a muffle furnace, a tubular furnace, and an atmospheric furnace. Examples of the continuous furnace include a rotary kiln, a screw conveyor furnace, a tunnel furnace, a belt furnace, a pusher furnace, and a lyp-type continuous furnace.

The porous body may be formed into a desired shape, thickness and the like by cutting or the like as necessary before the impregnation step.

In the impregnation step, subsequently, a solution containing the thermally curable composition is prepared in an impregnation device, and the porous body is immersed in the solution, whereby the pores of the porous body are impregnated with the thermally curable composition.

The impregnation step may be carried out under either reduced pressure conditions or pressurized conditions, or may be carried out by combining impregnation under reduced pressure conditions and impregnation under pressurized conditions. When the impregnation step is performed under reduced pressure conditions, the pressure in the impregnation device may be, for example, 1000 Pa or lower, 500 Pa or lower, 100 Pa or lower, 50 Pa or lower, or 20 Pa or lower. When the impregnation step is performed under pressurized conditions, the pressure in the impregnation device may be, for example, 1 MPa or higher, 3 MPa or higher, 10 MPa or higher, or 30 MPa or higher.

When the porous body is impregnated with the thermally curable composition, the thermally curable composition may be heated. By heating the thermally curable composition, the viscosity of the solution is adjusted and impregnation into the porous body is facilitated. The temperature to which the thermally curable composition is heated for impregnation may be above the temperature T1 described below. In this case, the temperature at which the thermally curable composition is heated for impregnation may be lower than the temperature T2 in the curing step described below. The upper limit of the temperature to which the thermally curable composition is heated may be equal to or lower than the temperature T1+20 °C.

In the impregnation step, the porous body is held in a state of being immersed in a solution containing a thermally curable composition for a specific time. The specifc time (immersion time) is not particularly limited, and may be, for example, 5 minutes or more, 30 minutes or more, 1 hour or more, 5 hours or more, 10 hours or more, 100 hours or more, or 150 hours or more.

In the semi-curing step, the porous body impregnated with the thermally curable composition is heated at a temperature T1 at which the cyanate compound reacts. Thus, the cyanate compound contained in the thermally curable composition reacts to obtain a semi-cured product. In this case, the cyanate compounds may react with each other, or the cyanate compound and a portion of the epoxy compound may react with each other. Meanwhile, in the thermally curable composition, as described above, the equivalent ratio of the epoxy group of the epoxy compound to the cyanate group of the cyanate compound is 1.0 or more. That is, in the semi-cured product, the epoxy compound is contained in excess of the cyanate compound as an epoxy equivalent, and these epoxy compounds remain in an uncured state. As a result, a semi-cured product of the thermally curable composition is obtained.

The temperature T1 is preferably 70°C or higher, more preferably 80°C or higher, and even more preferably 90°C or higher, from the viewpoint of sufficiently impregnating the porous body with the semi-cured product,. The temperature T1 is preferably 180°C or lower, more preferably 150°C or lower, and still more preferably 120°C or lower, from the viewpoint of reducing a change in viscosity with time. The temperature T1 refers to the ambient temperature when the porous body impregnated with the thermally curable composition is heated.

The heating time in the semi-curing step may be 1 hour or more, 3 hours or more, or 5 hours or more, and may be 12 hours or less, 10 hours or less, or 8 hours or less.

In the semi-cured product composite described above, since some compounds (mainly epoxy compounds) are contained in an uncured state, adhesion to an adherend is more excellent than in a cured product in which the thermally curable composition is completely cured. In addition, in this semi-cured product composite, since the uncured state is maintained for a long period of time unless heating is performed at a temperature at which the uncured compound is cured (details will be described later), it is possible to easily maintain a desired viscosity that is excellent in an adhesive property to an adherend. Thus, a semi-cured product composite having excellent handling properties can be obtained.

<Cured product composite>

By heating the semi-cured product composite described above at a temperature higher than the temperature T1, a cured product composite can be obtained. That is, the cured product composite according to an embodiment contains a porous body and a cured product of a thermally curable composition impregnated in the porous body. The thermally curable composition is similar to the embodiment described above.

The cured product composite can be obtained by heating the semi-cured product composite described above at a higher temperature. A method for producing a cured product composite according to one embodiment includes a step of impregnating a porous body with a thermally curable composition containing an epoxy compound and a cyanate compound (impregnation step), and a step of heating the porous body impregnated with the thermally curable composition at a temperature T1 at which the epoxy compound and the cyanate compound react, and then heating the porous body at a temperature T1 higher than the temperature T2 (curing step). The impregnation step is similar to the embodiment described above.

In the curing step, first, the porous body impregnated with the thermally curable composition is heated at a temperature T1 at which the cyanate compound reacts. The heating conditions at this time may be the same conditions as those in the semi-curing step in the method for producing a semi-cured product composite described above.

Subsequently, the porous body is heated at a temperature T1 higher than the temperature T2. In one embodiment, the temperature T2 may be a temperature at which a self-polymerization reaction of the epoxy compound occurs. Accordingly, the thermally curable composition may be completely cured by curing the uncured epoxy compound contained in the semi-cured product through a self-polymerization reaction.

When the thermally curable composition contains the above-described epoxy compound curing agent, the temperature T2 may be a temperature at which the epoxy compound and the epoxy compound curing agent react with each other. In this case, the epoxy compound and the curing agent react with each other to form a cross-linked structure, thereby completely curing the thermally curable composition.

The temperature T2 is preferably 150°C or higher, more preferably 180°C or higher, and still more preferably 200°C or higher. The temperature T2 is preferably 260°C or lower, more preferably 240°C or lower, and even more preferably 220°C or lower, from the viewpoint of volatilization of low molecular weight components contained in the composition and heat stability of the composition. The temperature T2 refers to the ambient temperature when heating the semi-cured product composite.

The heating time in the temperature T2 may be 1 hour or more, 5 hours or more, or 10 hours or more, and may be 30 hours or less, 25 hours or less, or 20 hours or less.

An embodiment of the present invention can also be regarded as a thermally curable composition that is suitably used by impregnating a porous body. The thermally curable composition used to impregnate the porous body according to an embodiment may contain an epoxy compound and a cyanate compound, wherein an equivalent ratio of an epoxy group of the epoxy compound to a cyanate group of the cyanate compound is 1.0 or more. The thermally curable composition is excellent as a composite capable of maintaining a high adhesive state by impregnating a porous body with the thermally curable composition and semi-curing the thermally curable composition. More specific embodiments of the thermally curable composition are as described above.

The semi-cured product composite described above can be used by, for example, forming it into a sheet shape

**EP 4 130 114 A1**

or the like and bonding it to an adherend. For example, a semi-cured product composite may be obtained by the above-described method, a thermally curable composition or a semi-cured product attached to an outer circumference of the composite may be removed, and the composite may be cut to a specifc thickness to form the semi-cured product composite in a sheet shape. The semi-cured product composite formed into a sheet shape is placed on an adherend and pressed while being heated in a temperature T2, for example, whereby the semi-cured product can be cured while being adhered to the adherend.

**Examples**

Hereinafter, the present invention will be described more specifically based on examples, but the present invention is not limited to the following examples.

The following materials were used to prepare the thermally curable composition.

Epoxy compound: trade name "HP-4032D" manufactured by DIC Corporation

Cyanate compound: trade name "TA-CN" manufactured by Mitsubishi Gas Chemical Co., Ltd.

Benzoxazine compound: trade name "F-a type benzoxazine" manufactured by SHIKOKU CHEMICALS CORPORATION

Ester compound: diphenyl phthalate, manufactured by Tokyo Chemical Industry Co., Ltd.

Metal-based curing accelerator: bis(2,4-pentanedionato) zinc (II), manufactured by Tokyo Chemical Industry Co., Ltd.

Amine-based curing accelerator: 4-dimethylaminopyridine (DMAP), manufactured by Tokyo Chemical Industry Co., Ltd.

[Preparation of thermally curable composition]

The epoxy compound, the cyanate compound, and the benzoxazine compound or the ester compound serving as the curing agent for the epoxy compound were weighed into a container so as to have the composition (parts by mass) shown in Table 1. Further, the curing accelerator was added in an amount shown in Table 1 with respect to 100 parts by mass of the total of the epoxy compound, the cyanate compound, and the curing agent for the epoxy compound, and all of them were mixed. Since the epoxy compound was in a solid state at room temperature, the epoxy compound was mixed while being heated to about 80°C. Thus, thermally curable compositions according to Examples and Comparative Example were prepared.

[Table 1]

| | | Example | | | | Comparative Example |
| --- | --- | --- | --- | --- | --- | --- |
| | | 1 | 2 | 3 | 4 | 1 |
| Epoxy compound | | 66 | 55 | 49 | 54 | 39 |
| Cyanate compound | | 23 | 34 | 51 | 18 | 61 |
| Equivalent ratio (epoxy group equivalent / cyanate group equivalent) | | 2.8 | 1.6 | 1 | 2.9 | 0.5 |
| Curing agent for epoxy compound | Benzoxazine compound | 11 | - | - | 28 | - |
| | Ester compound | - | 11 | - | - | - |
| Curing accelerator | Organic metal salt | 0.01 | 0.01 | 0.01 | 0.01 | - |
| | Amine compound | - | 0.3 | - | - | 0.01 |
| | Phosphorus compound | - | - | - | - | 1 |

[Evaluation of Viscosity Behavior]

The thermally curable compositions according to Examples and Comparative Example were cured by heating under conditions of 120°C and atmospheric pressure. At the same time as heating, the viscosity of the thermally curable composition was measured using a rotary viscometer at a shear rate of 10 (1/sec) to evaluate the change in viscosity of the thermally curable composition with respect to heating time. The results are shown in FIG. 1. FIG. 1(a) shows the results of Example 1, 2 and 4, FIG. 1(b) shows the results of Example 3, and FIGs. 1(a) and 1(b) show the results of

a8

Comparative Example 1 for comparison. As shown in FIGs. 1(a) and 1(b), when the thermally curable compositions of Examples 1 to 4 were heated at 120°C (corresponding to the temperature T1 in the above-described embodiment) for a specifc time, the viscosity of the thermally curable compositions became substantially constant within the range of $1 \times 10^3$ to $1 \times 10^5$ Pa·s. That is, it was found that by using the thermally curable composition containing the epoxy compound and the cyanate compound so that the epoxy group equivalent / cyanate group equivalent is 1.0 or more, the semi-cured product of the thermally curable composition can be easily adjusted to a state having excellent adhesiveness compared to the case of using the thermally curable composition of Comparative Example 1 in which the equivalent ratio is less than 1.0. In the thermally curable composition of Example 4, since the benzoxazine compound that reacts at a temperature higher than 120°C was added in a larger amount than in Example 1, more unreacted epoxy compound remained, and the viscosity became substantially constant at $1 \times 10^6$ Pa·s or less.

[Production of semi-cured product composite]

An amorphous boron nitride powder (manufactured by Denka Company Limited, oxygen content: 1.5%, boron nitride content: 97.6%, average particle diameter: 6.0 $\mu$m) and a hexagonal boron nitride powder (manufactured by Denka Company Limited, oxygen content: 0.3%, boron nitride content: 99.0%, average particle diameter: 30.0 $\mu$m) were weighed to be 40.0% by weight and 60.0% by weight, respectively.

The mixed powder was filled in a mold and press-molded under 5 MPa pressure to obtain a molded body. Next, using a cold isostatic pressing (CIP) device (manufactured by Kobe Steel, Ltd., trade name: ADW800), the molded body was compressed by applying pressures of 20 to 100 MPa. The compressed molded body was sintered by being held at 2000°C for 10 hours using a batch-type high-frequency oven (trade name: FTH-300-1H, manufactured by Fuji Electric Wave Industry Co., Ltd.) to prepare a porous body. Firing was performed by adjusting the atmosphere in the oven to a nitrogen atmosphere while allowing nitrogen to flow in the oven at a flow rate of 10L / min under standard conditions.

The porous body prepared as described above was impregnated with each of the thermally curable compositions according to Examples 1 to 4 by the following method. First, the porous body and the thermally curable composition contained in the vessel were placed in a vacuum heating impregnation device (manufactured by KYOSIN ENGINIEERING CORPORATION, trade name: G-555AT-R). Next, the inside of the apparatus was degassed for 10 minutes at a temperature of 100°C and a pressure of 15 Pa. After degassing, while maintaining the same conditions, the porous body was immersed in the thermally curable composition for 40 minutes to impregnate the porous body with the thermally curable composition.

Thereafter, the vessel containing the porous body and the thermally curable composition was taken out and placed in a pressurizing and heating impregnation device (manufactured by KYOSIN ENGINIEERING CORPORATION, trade name: HP 4030AA-H45), and held at a temperature of 130°C and a pressure of 3.5 MPa for 120 minutes to further impregnate the porous body with the thermally curable composition. Thereafter, the nitride sintered body was taken out from the apparatus and heated for a specifc time under conditions of a temperature of 120°C and atmospheric pressure. As a result, a semi-cured product composite having excellent adhesion could be easily produced.

[Production of cured product composite]

When the obtained semi-cured product composite was put into a pressure heating impregnation device and further heated for 5 hours under conditions of a temperature of 200°C and atmospheric pressure, the semi-cured product of the thermally curable composition was further cured, and a cured product composite having no adhesion could be prepared.

**Claims**

1. A semi-cured product composite comprising:

   a porous body; and
   a semi-cured product of a thermally curable composition impregnated in the porous body,
   wherein the thermally curable composition comprises an epoxy compound and a cyanate compound, and an equivalent ratio of an epoxy group of the epoxy compound to a cyanate group of the cyanate compound in the thermally curable composition is 1.0 or more.

2. The semi-cured product composite according to claim 1, wherein the thermally curable composition further comprises a curing agent for the epoxy compound.

3. The semi-cured product composite according to claim 2, wherein the curing agent comprises at least one selected from the group consisting of a benzoxazine compound, an ester compound, and a phenol compound.

4. A method for producing a semi-cured product composite, comprising:

impregnating a porous body with a thermally curable composition comprising an epoxy compound and a cyanate compound; and
heating the porous body impregnated with the thermally curable composition at a temperature T1 at which the cyanate compound reacts,
wherein an equivalent ratio of an epoxy group of the epoxy compound to a cyanate group of the cyanate compound in the thermally curable composition is 1.0 or more.

5. The method for producing a semi-cured product composite according to claim 4, wherein the thermally curable composition further comprises a curing agent for the epoxy compound.

6. The method for producing a semi-cured product composite according to claim 5, wherein the curing agent comprising at least one selected from the group consisting of a benzoxazine compound, an ester compound, and a phenol compound.

7. A cured product composite comprising:

a porous body; and
a cured product of a thermally curable composition impregnated in the porous body,
wherein the thermally curable composition comprises an epoxy compound and a cyanate compound, and an equivalent ratio of an epoxy group of the epoxy compound to a cyanate group of the cyanate compound in the thermally curable composition is 1.0 or more.

8. The cured product composite according to claim 7, wherein the thermally curable composition further comprises a curing agent for the epoxy compound.

9. The cured product composite according to claim 8, wherein the curing agent comprises at least one selected from the group consisting of a benzoxazine compound, an ester compound, and a phenol compound.

10. A method for producing a cured product composite, comprising:

impregnating a porous body with a thermally curable composition comprising an epoxy compound and a cyanate compound; and
heating the porous body impregnated with the thermally curable composition at a temperature T1 at which the cyanate compound reacts; and then at a temperature T2 higher than the temperature T1,
wherein an equivalence ratio of an epoxy group of the epoxy compound to a cyanato group of the cyanate compound in the thermally curable composition is 1.0 or more.

11. The method for producing a cured product composite according to claim 10, wherein the temperature T2 is a temperature at which a self-polymerization reaction of the epoxy compound occurs.

12. The method for producing a cured product composite according to claim 10, wherein the thermally curable composition further comprises a curing agent for the epoxy compound, and the temperature T2 is a temperature at which the epoxy compound and the curing agent react with each other.

13. The method for producing a cured product composite according to claim 12, wherein the curing agent comprises at least one selected from the group consisting of a benzoxazine compound, an ester compound, and a phenol compound.

14. A thermally curable composition used for being impregnated into a porous body, the thermally curable composition comprising:

an epoxy compound; and
a cyanate compound,

wherein an equivalent ratio of an epoxy group of the epoxy compound to a cyanate group of the cyanate compound is 1.0 or more.

15. The thermally curable composition according to claim 14, further comprising a curing agent for the epoxy compound.

16. The thermally curable composition according to claim 15, wherein the curing agent comprises at least one selected from the group consisting of a benzoxazine compound, an ester compound, and a phenol compound.

## Fig.1

(a)

(b)

## INTERNATIONAL SEARCH REPORT

| International application No. |
|---|
| PCT/JP2021/013397 |

**A. CLASSIFICATION OF SUBJECT MATTER**
C08J 5/24(2006.01)i; C04B 41/83(2006.01)i
FI: C08J5/24 CFC; C04B41/83 D
According to International Patent Classification (IPC) or to both national classification and IPC

**B. FIELDS SEARCHED**

Minimum documentation searched (classification system followed by classification symbols)
C08J5/24; C04B41/83

| Documentation searched other than minimum documentation to the extent that such documents are included in the fields searched | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2014-185222 A (MITSUBISHI GAS CHEMICAL CO., INC.) 02 October 2014 (2014-10-02) claims, paragraphs [0041], [0054]-[0056], examples 1, 2, 4-9, comparative examples 2-4 | 1-16 |
| X | WO 2014/061812 A1 (MITSUBISHI GAS CHEMICAL CO., INC.) 24 April 2014 (2014-04-24) claims, paragraphs [0105], [0107], [0114], [0115], examples 5-14, 22-31 | 1-16 |
| X | WO 2017/006898 A1 (MITSUBISHI GAS CHEMICAL CO., INC.) 12 January 2017 (2017-01-12) claims, paragraphs [0038]-[0040], [0054], [0056], [0062], examples 1, 2, 4, comparative examples 1-4 | 1-16 |
| X | WO 2014/112464 A1 (MITSUBISHI GAS CHEMICAL CO., INC.) 24 July 2014 (2014-07-24) claims, paragraphs [0066], [0067], [0069], examples 1, 4, 9, 10 | 1-16 |
| X | WO 2015/033731 A1 (MITSUBISHI GAS CHEMICAL CO., INC.) 12 March 2015 (2015-03-12) claims, paragraphs [0036], [0071], [0076], examples | 1-16 |

☒ Further documents are listed in the continuation of Box C.    ☒ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 09 June 2021 (09.06.2021) | 22 June 2021 (22.06.2021) |

| Name and mailing address of the ISA/ | Authorized officer |
|---|---|
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

**INTERNATIONAL SEARCH REPORT**

| International application No. |
|---|
| PCT/JP2021/013397 |

C (Continuation).   DOCUMENTS CONSIDERED TO BE RELEVANT

| Category* | Citation of document, with indication, where appropriate, of the relevant passages | Relevant to claim No. |
|---|---|---|
| X | JP 2011-148919 A (PANASONIC ELECTRIC WORKS CO., LTD.) 04 August 2011 (2011-08-04) claims, paragraphs [0074], [0078], [0079], examples 1, 3, 6, 8, 10-13, comparative examples 1, 5, 8 | 1-16 |
| X | WO 2019/167579 A1 (TORAY INDUSTRIES, INC.) 06 September 2019 (2019-09-06) claims, paragraph [0059], examples 10, 11, 13, 14, 27, 29, comparative examples 7, 11, 12, 14, 15 | 1-16 |
| A | WO 2017/155110 A1 (DENKA COMPANY LIMITED) 14 September 2017 (2017-09-14) entire text | 1-16 |
| A | WO 2018/181606 A1 (DENKA COMPANY LIMITED) 04 October 2018 (2018-10-04) entire text | 1-16 |
| A | US 2019/0016644 A1 (ZHANGJIAGANG INSTITUTE OF INDUSTRIAL TECHNOLOGIES SOOCHOW UNIVERSITY) 17 January 2019 (2019-01-17) claims, examples | 1-16 |
| A | WO 2019/172345 A1 (DENKA COMPANY LIMITED) 12 September 2019 (2019-09-12) entire text | 1-16 |

Form PCT/ISA/210 (continuation of second sheet) (January 2015)

**INTERNATIONAL SEARCH REPORT**
Information on patent family members

International application no.

PCT/JP2021/013397

| Patent Documents referred in the Report | Publication Date | Patent Family | Publication Date |
|---|---|---|---|
| JP 2014-185222 A | 02 Oct. 2014 | (Family: none) | |
| WO 2014/061812 A1 | 24 Apr. 2014 | US 2015/0267047 A1 claims, paragraphs [0133], [0135], [0142], [0143], examples EP 2910588 A1 CN 104736588 A KR 10-2015-0072425 A SG 11201502925U A TW 201434945 A CN 111393854 A | |
| WO 2017/006898 A1 | 12 Jan. 2017 | US 2018/0179355 A1 claims, paragraphs [0070]-[0072], [0087], [0089], [0090], examples EP 3321322 A1 CN 107709456 A KR 10-2018-0027419 A TW 201708345 A | |
| WO 2014/112464 A1 | 24 Jul. 2014 | US 2015/0344733 A1 claims, paragraphs [0076], [0077], [0082], examples EP 2947122 A1 CN 105073899 A KR 10-2015-0105417 A SG 11201505058P A TW 201437273 A | |
| WO 2015/033731 A1 | 12 Mar. 2015 | US 2016/0219700 A1 claims, paragraphs [0063], [0098], [0110], examples EP 3045283 A1 CN 105517767 A KR 10-2016-0053920 A | |
| JP 2011-148919 A | 04 Aug. 2011 | (Family: none) | |
| WO 2019/167579 A1 | 06 Sep. 2019 | (Family: none) | |
| WO 2017/155110 A1 | 14 Sep. 2017 | US 2019/0092695 A1 claims, examples EP 3428223 A1 KR 10-2018-0124915 A CN 109153801 A TW 201800365 A | |
| WO 2018/181606 A1 | 04 Oct. 2018 | US 2020/0031723 A1 claims, examples EP 3605602 A1 CN 110168719 A KR 10-2019-0132395 A | |

Form PCT/ISA/210 (patent family annex) (January 2015)

**INTERNATIONAL SEARCH REPORT**
Information on patent family members

International application no.

PCT/JP2021/013397

| Patent Documents referred in the Report | Publication Date | Patent Family | Publication Date |
|---|---|---|---|
| US 2019/0016644 A1 | 17 Jan. 2019 | WO 2017/121204 A1 claims, examples CN 105419328 A | |
| WO 2019/172345 A1 | 12 Sep. 2019 | CN 111356669 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2014196496 A